**Europäisches Patentamt**

**European Patent Office**

**Office européen des brevets**

(11) Publication number: **0 223 854**

**B1**

# (12) EUROPEAN PATENT SPECIFICATION

(45) Date of publication of patent specification: **03.10.90**

(51) Int. Cl.⁵: **H 03 G 3/20, H 03 F 3/58**

(21) Application number: **86904492.5**

(22) Date of filing: **23.05.86**

(86) International application number:
**PCT/US86/01126**

(87) International publication number:
**WO 86/07216 04.12.86 Gazette 86/26**

(54) **RF INPUT DRIVE SATURATION CONTROL LOOP.**

(30) Priority: **31.05.85 US 740092**

(43) Date of publication of application:
**03.06.87 Bulletin 87/23**

(45) Publication of the grant of the patent:
**03.10.90 Bulletin 90/40**

(84) Designated Contracting States:
**BE DE FR GB IT NL**

(56) References cited:
**WO-A-84/04215**
**GB-A-2 060 292**
**US-A-4 066 965**

**Rundfunktechnische Mitteilungen, vol. 24, no. 1, January 1980, (Hamburg, DE) W. Höfer: "Entwicklung eines Sendebegrenzers in PCM-Technik", pages 19-25**

(73) Proprietor: **Hughes Aircraft Company**
**7200 Hughes Terrace P.O. Box 45066**
**Los Angeles, California 90045-0066 (US)**

(72) Inventor: **MOLLETT, Larry, R.**
**1164 West Valencia, No. 8**
**Fullerton, CA 92633 (US)**
Inventor: **GOCZALK, Robert, W.**
**4 Pearson Street RFD 3**
**Litchfield, New Hampshire 03103 (US)**

(74) Representative: **Kuhnen, Wacker & Partner**
**Schneggstrasse 3-5 Postfach 1553**
**D-8050 Freising (DE)**

## Description

Background of the invention

The present invention relates to control of the input drive level to travelling wave tube (TWT) amplifiers, and more particularly to improved techniques for optimizing TWT efficiency over a range of operating frequencies.

TWT amplifiers are in wide use in a variety of applications in which amplification of RF energy is required. Limitations imposed by TWT characteristics and manufacturing techniques result in a frequency-dependent input RF drive characteristic. These limitations can result in significant variations even between tubes of the same manufacturer and within the same manufacturing sequence. An optimum drive level for a given frequency will yield a maximum RF output power. Beyond that optimum drive level, defocusing and marked reduction of beam current transmission and TWT efficiency occurs. This results in increased power dissipation in the TWT RF structure and a decreased RF output power.

Insofar as applicants are aware, in the past, fixed, frequency dependent RF attenuators or gain equalizers tuned for each TWT amplifier have been employed to provide the optimum input RF drive level to the TWT. An alternative is to provide means for flattening the TWT amplifier gain and RF input driver characteristics for the frequencies used. Both alternatives are relatively expensive and are affected by the performance degradation of the amplifier during its operating life.

Document US—A—4,066,965 discloses a system and thus a method for optimizing the RF input drive level to a microwave amplifier, especially to a gridded travelling wave tube, across the entire RF band. The system is coupled to an input RF drive signal by a variable RF attenuator which controls the drive to the microwave amplifier. The RF power output of the microwave amplifier is sensed by a detector producing a signal indicative of the output power level. In order to optimize the RF power output the sensed signal indicative of the output power level is processed by a processor unit and coupled back to the RF attenuator controlled by the processor unit based upon whether the power output is increasing or decreasing. The feedback circuit may be used across a particular range of frequencies. It is a disadvantage of the circuit not to produce an optimized constant RF power output but only an oscillating value thereof.

Document WO—A—84/04215 relates to a stabilized microwave power amplifier system operated in manual mode or in servo mode. The level of power output is preset by the operator in the manual mode. In the servo mode the desired level of power output is automatically preserved. The stabilization of the level of power output is attained by sensing the output and using a feedback circuit to vary an input variable attenuator to the amplifier based upon whether the output is greater than the desired output or not. The system is producing a relative stabilized power output but no optimized power output. Furthermore, the output power is oscillating about the value of the desired power output.

Finally, document GB—A—2 060 292 relates to transit level control in transmitters. The described system also comprises a variable attenuator, an output sensor and means for controlling the variable attenuator in response to variations in the transmitter power output. In order to achieve a more stabilized output the variable attenuator in turn comprises a first switched attenuator and a second variable attenuator, the response time of the first attenuator to variations of the power output is being substantially slower than the response time of the second attenuator. The system, however, is also producing oscillating power output.

It is, therefore, an object of the present invention to provide an apparatus and a method for optimizing the RF input drive level to a microwave amplifier over an input frequency band width in such a way to produce an optimized constant RF output power level.

It would therefore be an advance in the art to provide an automated system for optimizing the RF drive level to a TWT amplifier, which provides an optimum RF drive for each frequency of concern, and allows for recalibration of the optimum RF drive as desired to compensate for aging of the TWT amplifier or other microwave chain components.

By a method in accordance to claim 1 and an apparatus in accordance to claim 7 the foregoing advantages and features are provided.

The system according to the invention comprises a programmable attenuator for selectively controlling the input drive level to the TWT, an RF detector for monitoring the output power level of the TWT, and a controller. The controller receives detector signals representative of the RF detector output and frequency signals representative of the RF exciter frequency to the TWT amplifier, and provides attenuator control signals to the programmable attenuator. The system is operable in a calibration mode, wherein for each exciter frequency of interest, the attenuator setting resulting in the maximum TWT output power is determined. These attenuator settings are then stored in memory, and are available for recall during the normal operating mode. In the normal mode, the system automatically sets the RF input drive at the optimum level, by setting the programmable attenuator to the predetermined setting corresponding to the present exciter frequency. The calibration mode may be rapidly repeated over the life of the TWT amplifier to accommodate changing characteristics as the elements of the TWT amplifier age or change due to other factors.

Brief description of the drawings

These and other features and advantages of the present invention will become more apparent from the following detailed description of an

3          EP 0 223 854 B1          4

exemplary embodiment thereof, as illustrated in the accompanying drawings, in which:

Figure 1 is a graph representing a typical TWT output power saturation curve.

Figure 2 is a simplified block diagram comprising the presently preferred embodiment of the invention.

Figure 3 is a flow chart illustrative of the RF calibration operation throughout a range of frequencies.

Figure 4 is a flow chart of the calibration operation at an individual frequency.

Figure 5 is a plot of the TWT output power as a function of time, in which the digital attenuator employed in the preferred embodiment is progressively programmed to particular settings, illustrating the dynamic calibration process at a particular frequency.

Figure 6 is a histogram of the number of samples for each attenuator setting counted during the dynamic calibration shown in Figure 5.

Figure 7 is a composite block diagram of the preferred embodiment.

Detailed description of the preferred embodiment

The present invention comprises a system for optimizing the RF input drive to a TWT amplifier. The following description is presented to enable a person skilled in the art to make and use the invention, and is provided in the context of a particular application and its requirements. Various modifications to the preferred embodiment may be apparent to those skilled in the art, however, and the present invention is not intended to be limited to the embodiment shown, but is intended to be accorded the widest scope consistent with the principles and novel features disclosed herein.

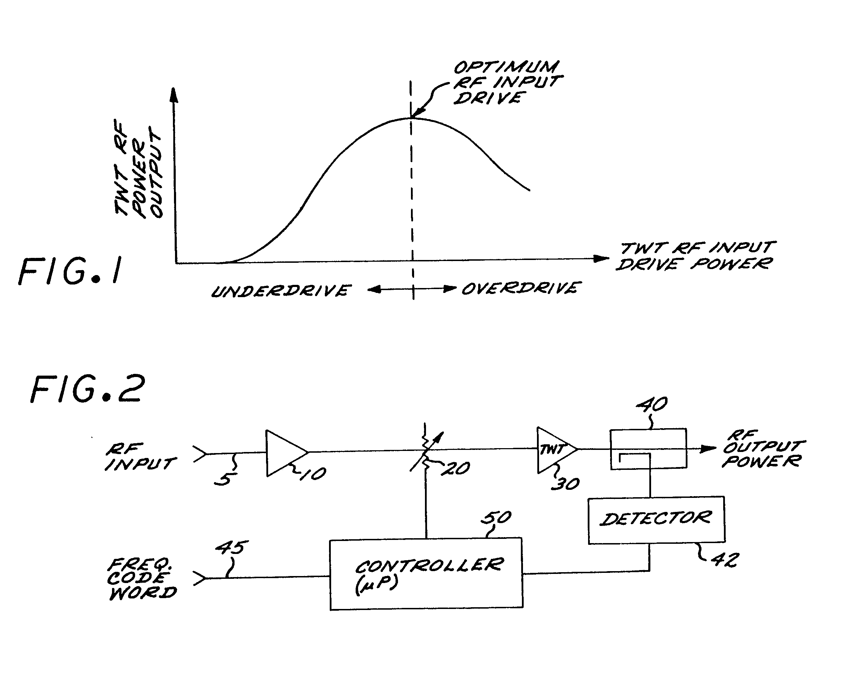

Figure 1 represents a typical saturation curve for a TWT amplifier. The output power of the TWT is plotted as a function of the RF input drive power. It is seen that there is one optimum input drive power level which can result in maximum output power. When the TWT is overdriven, the output power is not only reduced, but the TWT operates in a less efficient mode.

The preferred embodiment comprises a system for automatically adjusting the input drive level to a TWT amplifier as a function of the input RF drive frequency. A simplified block diagram is illustrated in Figure 2. The RF exciter signal is applied on line 5 to the RF solid state amplifier 10, whose output establishes an input RF drive level to the TWT 30. The power level of the RF exciter signal is typically in the milliwatt range, insufficient to effectively drive the TWT. Thus, a solid state RF amplifier such as the amplifier 10 is normally employed to provide a first stage of amplification, resulting in an RF input power level to the TWT in the watt range.

The output of the solid state amplifier 10 is coupled through variable attenuator 20 to the input of TWT amplifier 30. The output of the TWT 30 is passed through coupler device 40. The coupled output 40 is provided on line 41 to RF detector 42. The detector output is a video signal whose level is representative of the detected power level from coupler 40; this video signal is provided to the controller 50. The controller 50 in turn provides a control signal to the variable attenuator 20, controlling the attenuation setting, dependent on the frequency of the RF input signal. The frequency of the RF exciter signal is provided as a digital frequency code word on line 45 to controller 50.

The digital attenuator 20 sets the TWT input drive level. The setting of attenuator 20 is controlled by a six-bit control word, and in the preferred embodiment has an attenuation resolution of 0.25 dB per step with a 15 dB range of control.

The system has two modes of operation, the calibration mode and the normal mode. In the calibration mode, the system determines the attenuator setting to obtain an optimum RF input level resulting in the maximum TWT power output. The attenuator setting resulting in the optimum TWT output power for each frequency is stored in a non-volatile memory. In the normal mode, the controller 50 automatically sets the attenuator 20 to the calibrated setting for the present exciter frequency.

A change in frequency, initiated by the external RF exciter system, is communicated to the controller 50 via the digital frequency code word on line 45. Alternatively, the system may include other means for determining the exciter frequency.

The drive control system operates in the calibrate mode as a "closed-loop" controller to optimize the TWT RF input drive for any frequency applied to its input. This is accomplished by using a calibration algorithm to increase the RF input drive to the TWT from a minimum (underdrive) to the optimum setting resulting in the optimum TWT output power level for each exciter frequency by varying the attenuator 20. The controller 50 continues to vary the drive about this optimum value until a predetermined number of samples of the TWT output power have been taken, and the corresponding attenuator setting resulting in the optimum output power is determined and stored for use during the normal mode.

The resulting calibration values are stored in a nonvolatile memory, such as an electrically erasable programmable read only memory (EEPROM) comprising controller 50. In the normal mode, the attenuator 20 is set in accordance with the stored EEPROM value which corresponds to the present frequency, thus maintaining optimum RF drive across the entire frequency band of interest.

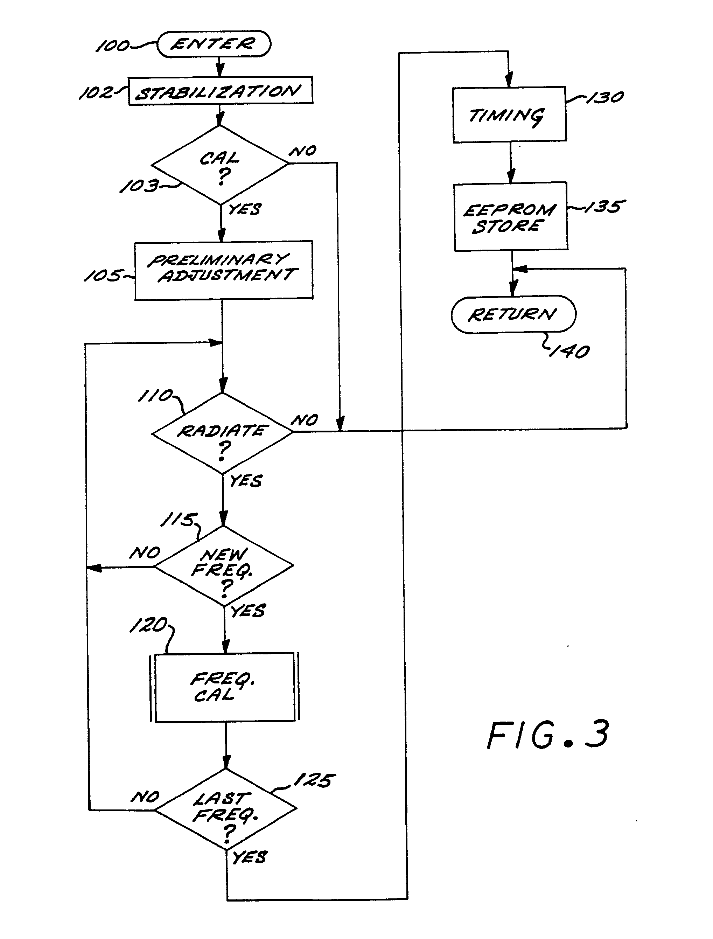

The general calibration algorithm is illustrated in the flow chart of Figure 3. After a stabilization delay to allow the TWT cathode current controller to stabilize to the desired cathode current level, at step 103, the TWT system is checked to determine whether the system is in condition for calibration. For example, high voltage and cathode current must be applied to the TWT and the system TWT

3

"radiate" command selected. If the calibration requirements are not met, the algorithm branches to return step 140, terminating the calibration process.

With the calibration requirements met at step 103, then at step 105, preliminary adjustments are made to the timing of the RF input drive pulses to the TWT as well as the timing of the TWT cathode current pulses. In the application of the preferred embodiment, the TWT amplifier is employed in a pulsed operation. Thus, to obtain TWT output power, the RF drive pulse and cathode current pulse should coincide. The preliminary timing adjustment conducted at step 105 substantially aligns the timing of the two pulses so that there will be TWT output power during the calibration mode.

In steps 110 and 115, the system "radiate" command and the frequency code word provided to the controller 50 are tested. If, at step 110, the radiate command is no longer selected, the calibration mode is terminated; otherwise, RF drive calibration will be performed at each exciter frequency. Thus, at step 115 the frequency code word is tested to determine if the frequency has already been calibrated. If the frequency code has not changed from the frequency at which the previous calibration was performed, the algorithm branches back to step 110 in a delay loop, until the exciter frequency is changed to a new frequency not yet calibrated.

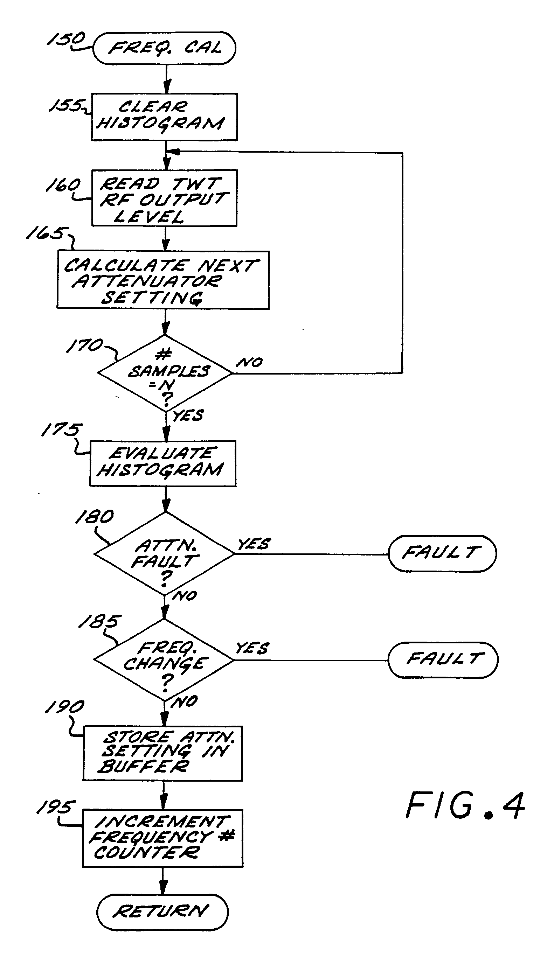

At step 120, the calibration for the optimum drive level for the selected frequency is performed. This step is described in more detail hereinbelow with respect to the flowchart of Figure 4. At step 125, the frequency code word is tested to determine whether the calibration has been performed at all of the frequencies of interest in the frequency band. This may be done by comparing the number of exciter frequencies at which the calibration has been performed with the predetermined total number of frequencies to be calibrated. If this is not the last frequency, the algorithm branches back to step 110, and the loop is repeated from that point for another exciter frequency.

After calibration has been performed at all frequencies of interest, final adjustment of timing is performed at step 130 to align the cathode current and RF input pulses. The specific details by which the final timing adjustment is carried out per se are not considered essential to the practice of the present invention. The results of both drive level and timing calibrations are then transferred from the controller buffer memory to the EEPROM for storage at step 135. The calibration algorithm is exited at step 140.

Figure 4 is a flowchart illustrating the sequence of operations for performing the input drive calibration at a single RF exciter frequency (step 120 of Figure 3). The attenuator 20 employed in the preferred embodiment may be set to sixty-four different attenuation settings. The controller 50 is adapted to perform a separate counter function for the number of times each of the sixty-four possible attenuator settings is selected during the individual frequency calibration. These sixty-four "counters" are implemented from processor registers or memory locations which are incremented once for each TWT pulse, i.e., each time the attenuation setting is changed. It is well known to those skilled in the programming art how to program a computer such as a microprocessor to carry out such a counting function, and the details of such a program need not be described in further detail.

The contents of these registers or counters may be employed to develop a histogram of the various attenuator settings through the particular calibration cycle. Thus, the controller is adapted to perform a histogram function to generate a histogram of the attenuator settings.

At step 155 of the individual frequency calibration cycle, the individual attenuator setting counters are initialized, i.e., set to zero, and the attenuator is set to the maximum attenuation level. Once the histogram and attenuation setting have been initialized, the TWT output power is sampled at step 160. This sampled power value is used to calculate the next attenuator setting, at step 165. If the power value increased over the power value for the preceding attenuator setting, the attenuator is changed to the next lower impedance setting. Each time a particular attenuator setting is selected, the corresponding histogram counter is incremented.

At step 170, a decision is made as to whether the number of output power samples equals N. N is a number which is experimentally determined to be the smallest number of samples which will result in an accurate calibration. As the number of samples is increased, the height of the peak in the histogram increases, at the expense of lengthening the calibration time. For the application of the preferred embodiment, N is selected to be 255. Thus, at step 170, if the number of samples taken does not equal 255, the algorithm loops back to step 160. If the number of samples does equal N, the algorithm proceeds to step 175.

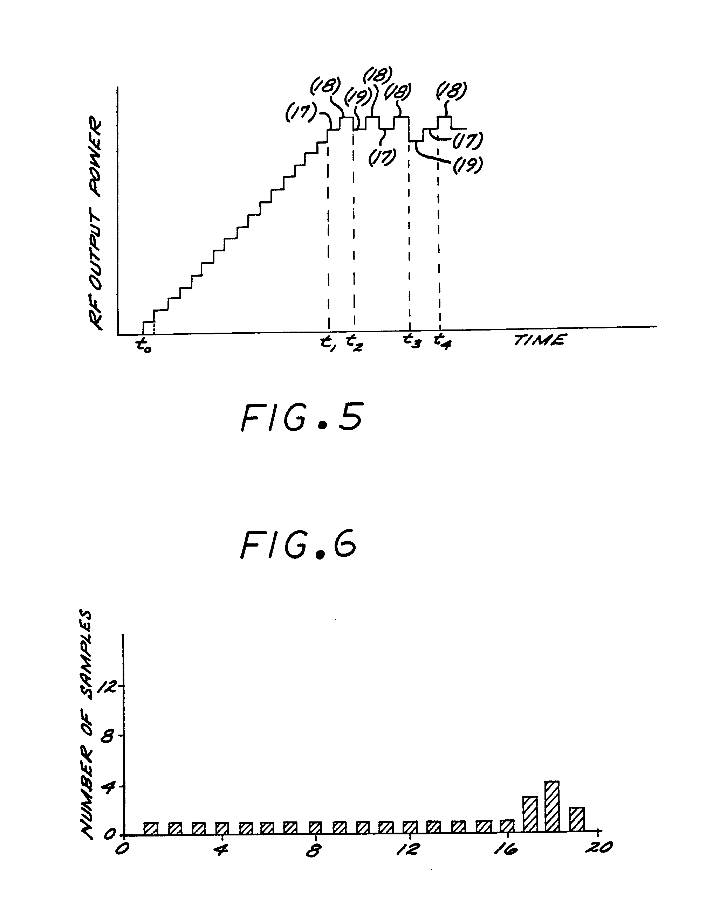

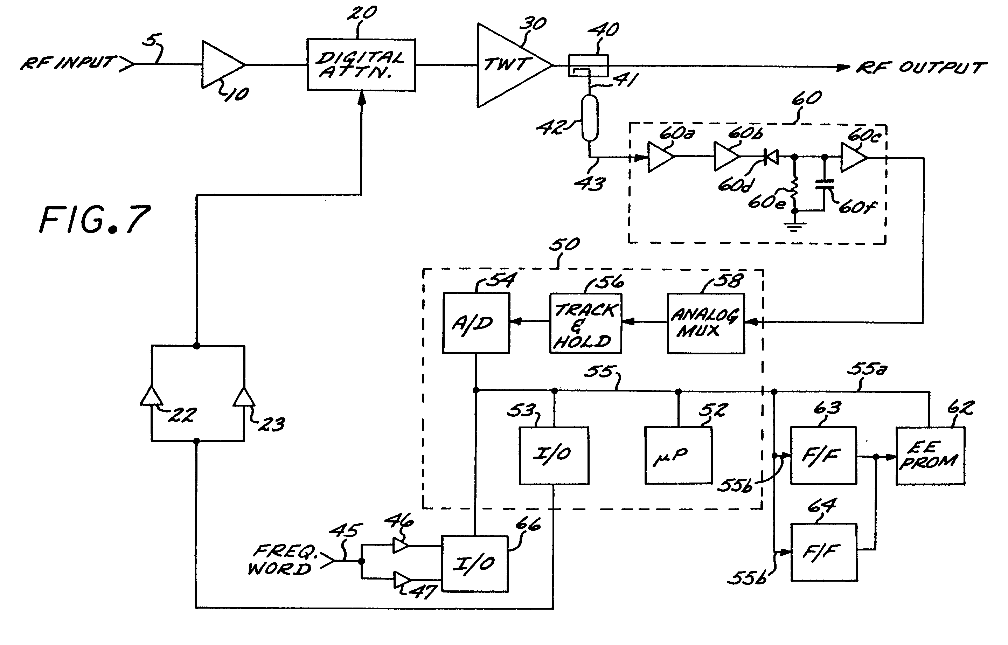

At step 175, the histogram developed by the counters for each attenuator setting is evaluated to find the counter with the highest value. Figures 5 and 6 illustrate the TWT output power sampling and the resultant histogram of attenuator settings which is evaluated to determine the optimal setting. In Figure 5, the RF output power increased after each sample from times $t_0$ to $t_1$. This corresponds to increases in the RF drive level and the use of attenuator settings 1 through 16. From times $t_1$ to $t_2$, increases in drive with settings 17 and 18 (indicated by the parenthetical numbers (17), (18) in Figure 5) also result in RF output power increases.

The algorithm which is employed in the preferred embodiment is adapted to change the attenuator setting by one bit if the difference between the output power samples (which have been digitized and read by the microprocessor,) before and after the change in attenuator setting is one bit or less. If the difference in power samples is two bits or more, then the attenuator setting is changed by two bits from its previous setting.

When the drive is increased by decreasing the attenuation to attenuator setting 19 at time $t_2$, a decrease in RF output power occurs. Since the RF output power decreased for an increase in drive level, the next drive level is decreased by the microprocessor by increasing the attenuation to setting 18. The calibration algorithm continues to resample output power levels about setting 18 to optimize the peak output power. At time $t_3$, the power level decreased by two units, resulting in a change in the attenuator setting of two bits, i.e., from setting 19 to 17. Thus, the attenuator setting sequence between times $t_1$ and $t_4$ is 17, 18, 19, 18, 17, 18, 19, 17, 18 updates the histogram counters, as illustrated in Figure 6. The sampling and histogram updating continues until the number of power samples reaches N.

The algorithm employed in the preferred embodiment to calculate the attenuator setting at step 165 operates by comparing the previous power sample A with the current power sample B before changing the attenuator. If the value of A is less than B, the attenuator setting is reduced to reduce the attenuation, either by one bit or two, as discussed above. Once the peak of the saturation curve is passed, then power sample A will be greater than power sample B. At that point, the attenuator setting is increased to increase the attenuation level. These steps are repeated until the number of samples equals the predetermined number N.

Once the predetermined number of samples is determined to have been taken at step 170, the histogram is evaluated at step 175 to find the counter with the highest number. At step 180 this counter setting is evaluated to determine whether the highest counter value corresponds to one of the limits of the variable attenuator, i.e., the highest or lowest attenuation. If so, this triggers a fault indicating the attenuation range is not capable of optimizing the RF drive and the calibration mode is exited. At step 185, the frequency code is tested to verify that the same frequency was used throughout the calibration cycle. If the frequency did change, a fault is also declared.

At step 190, the attenuator setting determined in step 175 to be optimum is stored in the buffer memory associated with the microprocessor. In the illustration of Figures 5 and 6, evaluation of the histogram will locate the highest counter setting as 18. This setting results in maximum RF output power from the TWT. At step 195, the frequency counter, which keeps track of the number of frequencies for which the calibration has been performed, is incremented.

While the flowcharts illustrated in Figures 3 and 4 may be implemented in different ways, an exemplary listing of source code which has been employed with the preferred embodiment to carry out the invention is set forth in Appendix A.

Referring now to Figure 7, the system comprising the preferred embodiment is illustrated in block diagram form. The RF exciter signal is provided on line 5 to RF solid state amplifier 10. The output of the amplifier 10 is passed through attenuator 20, and the attenuator output comprises the RF drive to the TWT 30. In the preferred embodiment, the attenuator 20 comprises a 6-bit digital attenuator such as that marketed by Hylectronics Corporation, Newton Road, Littleton, Massachusetts, model PX8, having a 15 dB range and a resolution of .25 dB per step.

RF coupler 40 is connected to the TWT 30 output, and its coupled output 41 provides a small part of the RF energy from the TWT 30 to RF detector 42. The detector 42 provides a video signal on line 43 whose amplitude is representative of the relative power output of the TWT 30.

The detector signal is passed to signal conditioner 60, which performs amplification and peak detection functions. The signal conditioner 60 comprises video amplifier 60a; in the preferred embodiment, a Fairchild differential video amplifier, model μA733, is advantageously employed as the video amplifier. The amplified signal is provided to a peak sampler circuit, comprising operational amplifiers 60b and 60c, diode 60d, resistor 60e and capacitor 60f. These elements represent a simplified schematic of the peak sampler circuit. Such circuits are well-known, and are discussed, for example, in the book "Electronic Circuits and Applications", by Steven D. Senturia and Bruce D. Wedlock, (John Wiley, 1975), at pages 208—210. The function of the peak sampler is to charge the capacitor 60f to the peak voltage level, and then to hold the voltage for a predetermined time interval determined by the R—C time constant of resistor 60e and capacitor 60f.

Because the TWT amplifier of the preferred embodiment is operated in a pulsed mode, the detected video signal pulses on line 43 are very short. The signal conditioning circuit 60 provides a useful output signal level which may be provided to track-and-hold module 56 through multiplexer 58.

Multiplexer 58 provides the capability of selectively switching one analog signal from several possible input signals; only the analog signal from circuit 60 is shown. This allows one of several signals to be provided to the analog-to-digital converter (ADC) 54 for conversion to a digital signal, which is provided as an input to microprocessor 52. In the preferred embodiment, a Datel-Intersil analog multiplexer, model MV-1606M is employed as multiplexer 58.

The track-and-hold module 56 comprises a hybrid video track and hold device such as that marketed by the Data Device Corporation as model ADH-50. The module 56 is adapted to rapidly track and hold the peak video signal level, enabling the ADC 54 to properly carry out the conversion. The ADC marketed by Datel-Intersil, Inc., 11 Cabot Boulevard, Mansfield, Massachusetts, as the model ADC-815 and the Intel Corporation microprocessor, model 8085, are employed in the preferred embodiment as ADC 54 and microprocessor 52, respectively.

An eight bit bus 55 allows digital signal communication among the output of ADC 54, the microprocessor 52, the non-volatile memory comprising EEPROM 62 and flip/flop devices 63 and 64, and input/output peripheral devices 53 and 66. In the preferred embodiment, the flipflop devices 63 and 64 are 54LS174-type hex D flip-flops; the EEPROM 62 is a model X2212 device, marketed by XICOR, Inc., 851 Buckeye Court, Milpitas, California. The peripheral devices 53 and 66 comprise Intel model 8155 devices.

The microprocessor is adapted to read/write data over bus 55 to/from EEPROM 62. The flip-flops 63 and 64 interface between the microprocessor 52 and EEPROM 62 via busses 55a, 55b and 55c and are employed to verify that data was correctly programmed into the EEPROM 62.

The 5-bit frequency word is provided on bus 45 to differential line receivers 46 and 47, which may be 26LS31 type devices, employed for noise isolation. The line receiver outputs are coupled to peripheral device 66, so as to be available to the microprocessor over data bus 55.

The peripheral device 53 is coupled to the digital attenuator 20 through line drivers 22, 23, which comprise 26LS33 type drivers in the preferred embodiment, to provide 6 differential bit pairs to the attenuator 20. The attenuator 20 further comprises a pair of corresponding line receivers (not shown) of the 26LS31 type. The line receivers and line drivers are employed in the preferred embodiment for noise isolation purposes, as the pulsed TWT amplifier is a high noise environment.

The analog output of device 56 is converted to a digital signal by ADC 54 and provided to an input port of microprocessor 52. Thus, the microprocessor 52 is able to monitor digital signals representative of the sampled RF output power level of the TWT.

The microprocessor 52 is coupled to EEPROM 62 to store and retrieve data, as described above. The output of the microprocessor 52 controls the attenuator setting through peripheral device 53 and line drivers 22, 23.

There has been described a novel system for optimizing the input drive to a TWT amplifier, which provides the capability for recalibration of the drive as the elements of the amplifier age. Another advantage of the system is that it is not dependent on measuring the actual RF input power level. In the disclosed embodiment of the invention, the input level is not monitored at all, and only relative changes in the output power are monitored by the system, which result from changes in the attenuation setting. Moreover, the actual attenuation introduced by the variable attenuator is not measured. Thus, the disclosed system does not depend on the accuracy of absolute attenuation or measured power levels. In a broad sense, the calibration mode may be viewed as an iterative process wherein an input drive parameter is varied to determine a calibrated drive parameter value which results in the optimum RF output power level for each frequency of interest. While the invention has been described in the context of a TWT amplifier, it is believed that the invention can be employed to optimize the input RF drive to any pass-through microwave amplifier.

**Claims**

1. A method for optimizing the input RF drive level to a microwave amplifier (30) over an input frequency bandwidth, comprising the steps of:

providing a controllable means (20) of varying the input drive level to the amplifier (30) in response to control signals;

providing a central controller (50) for providing said control signals to said controllable means (20), said controller (50) being adapted for operation in a calibration mode;

in said calibration mode, for each frequency of interest, determining through an iterative process of varying an input drive parameter the calibrated value of the input drive parameter which results in the maximum power output; characterized in that

said controller (50) is adapted for operation in said calibration mode and a normal amplifier operational mode;

in said normal amplifier operational mode, setting said input drive parameter value at the calibrated value corresponding to the present frequency.

2. The method of Claim 1 wherein said calibration mode further comprises the step of storing in a memory device (62) data representative of said calibrated value for each frequency of interest.

3. The method of Claim 1 wherein said step of determining said calibrated parameter values comprises iteratively changing the attenuation level of a programmable attenuator (20) adapted to selectively attenuate the input drive to the amplifier (30), and wherein said input drive parameter comprises the programmable attenuator setting.

4. The method of Claim 3 wherein said iterative process comprises the steps of:

(i) programming said attenuator (20) to an initial setting;

(ii) sampling the output;

(iii) determining a new attenuator setting and programming the attenuator (20) to the new setting; and

(iv) repeating steps (ii) and (iii) until a predetermined number of samples have been taken.

5. The method of Claim 4 wherein the step of determining a new attenuator setting comprises:

(i) determining whether the previous change in the attenuator setting resulted in increased output power; and

(ii) if so, decreasing the attenuator setting in the same direction as the previous attenuator setting change; or

(iii) if not, increasing the attenuator setting in the opposite direction from the previous change.

6. The method of Claim 5 wherein the step of determining the calibrated value of the attenuator setting comprises the step of counting the number of times each attenuator setting is used during said iterative process, and determining the calibrated value as that attenuator setting which received the maximum usage during said iterative process.

7. A system for optimizing the RF input drive to a microwave amplifier (30), comprising;

a programmable attenuator means (20) for selectively attenuating the RF input drive to the amplifier (30);

detector means (40) for detecting the RF power output of the amplifier (30) and providing a detector signal indicative of the output power level; and

controller means (50) operable in a calibration mode, said controller (50) being responsive to said detector (40) signals; characterized in that means for providing frequency signals indicative of the frequency of the RF input drive to the amplifier (30) are provided;

said controller means (50) is operable in said calibration mode and in a normal operating mode;

said controller (50) being responsive to said detector signals and said frequency signals during said calibration mode to determine a calibration attenuator setting for each frequency of interest; and

said controller (50) being responsive to said frequency signal in said normal operating mode to program said attenuator (30) to said calibrated attenuator setting corresponding to the value of said frequency signal.

8. The system of Claim 7 further comprising memory means (62) for storing data representative of said calibrated attenuator settings, and wherein said controller means (50) is adapted to enter said data in said memory means (62) during the calibration mode, and to retrieve data in dependence on the present frequency signal during the normal operating mode.

9. The system of Claim 8 wherein said controller means (50) determines the calibration attenuator setting through an iterative process of programming the attenuator means (20) to selected settings to vary the RF input drive to the amplifier (30), and comparing the detector signal from the detector means (40) at each programmed setting of the attenuator means (20) against prior settings of the attenuator means (20), and selecting the attenuator setting which results in the maximum power output of the amplifier (30).

10. The system of Claim 9 wherein the iterative process comprises the steps of:

(i) programming said attenuator (20) to an initial setting;

(ii) receiving the detector (40) signal indicative of the output power level;

(iii) programming said attenuator (20) to a different setting;

(iv) where the detector (40) signal indicates an increased output power level at the different setting, increasing the attenuator (20) setting in the same direction as the previous attenuator setting;

(v) where the detector (40) signal indicates a decreased output power level at the different setting, decreasing the attenuator (20) setting in the opposite direction as the previous attenuator setting;

(vi) repeating steps (iii) through (v) until a selected number of samples have been taken; and

(vii) determining the calibration attenuator setting by counting the number of times each attenuator setting is used during said iterative process, and selecting that attenuator setting which received the highest usage.

**Patentansprüche**

1. Ein Verfahren zur Optimierung des HF-Eingangsansteuerungspegels zu einem Mikrowellenverstärker (30) über eine Eingangsfrequenzbandbreite mit den Schritten:

Bereitstellen einer Regeleinrichtung (20) zum Variieren des Eingangsansteuerungspegels zu dem Verstärker (30) als Antwort auf Steuersignale;

Bereitstellen eines zentralen Reglers (50) zum Bereitstellen der Steuersignale zu der Regeleinrichtung (20), wobei der Regler (50) für den Betrieb in einem Kalibrierungsmodus angepaßt ist;

Bestimmen—in dem Kalibrierungsmodus für jede Frequenz von Interesse—des kalibrierten Wertes des Eingangsansteuerungsparameters, welcher eine maximale Ausgangsleistung zur Folge hat, durch einen iterativen Prozeß des Variierens eines Eingangsansteuerungsparameters; dadurch gekennzeichnet, daß

der Regler (50) zum Betrieb in dem Kalibrierungsmodus und einem normalen Verstärkerbetriebsmodus angepaßt ist;

in dem normalen Verstärkerbetriebsmodus der Eingangsansteuerungsparameter auf einen kalibrierten Wert gesetzt wird, welcher der gegenwärtigen Frequenz entspricht.

2. Das Verfahren nach Anspruch 1, worin der Kalibrierungsmodus des weiteren den Schritt des Speicherns von Daten, welche repräsentativ einem kalibrierten Wert für jede Frequenz von Interesse sind, in ein Speicherbauteil (62), aufweist.

3. Das Verfahren nach Anspruch 1, worin der Schritt des Bestimmens der kalibrierten Parameterwerte iteratives Verändern des Abschwächungspegels eines programmierbaren Dämpfungsgliedes (20) aufweist, welches angepaßt ist zum selektiven Abschwächen der Eingangsansteuerung zu dem Verstärker (30), und worin der Eingangsansteuerungsparameter die programmierbare Dämpfungsgliedeinstellung aufweist.

4. Das Verfahren nach Anspruch 3, worin der iterative Prozeß die Schritte aufweist:

(i) Programmieren des Dämpfungsgliedes (20) auf eine Anfangseinstellung;

(ii) Abtasten des Ausgangs;

(iii) Bestimmen einer neuen Dämpfungsgliedeinstellung und Programmieren des Dämpfungsglieds (20) auf eine neue Einstellung; und

(iv) Wiederholen der Schritte (ii) und (iii) bis eine vorherbestimmte Anzahl von Abtastungen durchgeführt wurde.

5. Das Verfahren nach Anspruch 4, worin der Schritt des Bestimmens einer neuen Dämpfungsgliedeinstellung aufweist:

(i) Bestimmen, ob der vorhergehende Wechsel der Dämpfungsgliedeinstellung ein Anwachsen der Ausgangsleistung zur Folge hat; und

(ii) wenn dem so ist, Vermindern der Dämpfungsgliedeinstellung in derselben Richtung wie der vorhergehende Dämpfungsgliedeinstellungswechsel; oder

(iii) wenn dem nicht so ist, Anwachsen der Dämpfungsgliedeinstellung in die entgegengesetzte Richtung zu dem vorhergehenden Wechsel.

6. Das Verfahren nach Anspruch 5, worin der Schritt des Bestimmens des Kalibrierungswertes der Dämpfungsgliedeinstellung den Schritt des Zählens der Anzahl jeder Dämpfungsgliedeinstellung aufweist, welche verwendet wird während des iterativen Prozesses, und das Bestimmen des kalibrierten Wertes als die Dämpfungsgliedeinstellung, welche die maximale Verwendung während des iterativen Verfahrens erhalten hat.

7. Ein System zum Optimieren der HF-Eingangsansteuerung zu einem Mikrowellenverstärker (30) mit

einer programmierbaren Dämpfungsgliedeinrichtung (20) zum selektiven Abschwächen der HF-Eingangsansteuerung zu dem Verstärker (30);

einer Detektorvorrichtung (40) zum Feststellen des HF-Leistungsausgangs des Verstärkers (30) und Bereitstellung eines Detektorsignals, welches den Ausgangsleistungspegel anzeigt; und

eine Reglervorrichtung (50), welche in einem Kalibrierungsmodus betreibbar ist, wobei der Regler (50) auf Detektorsignale anspricht; dadurch gekennzeichnet, daß

eine Vorrichtung zum Bereitstellen von Frequenzsignalen vorgesehen ist, welche die Frequenz der HF-Eingangsansteuerung zu dem Verstärker (30) anzeigt;

die Regelvorrichtung (50) in dem Kalibrierungsmodus und in einem normalen Betriebsmodus betreibbar ist;

die Reglervorrichtung (50) auf die Detektorsignale und die Frequenzsignale während des Kalibrierungsmodus anspricht, um eine Kalibrierungsdämpfungsgliedeinstellung für eine Frequenz von Interesse zu bestimmen; und

der Regler (50) auf das Frequenzsignal in dem normalen Betriebsmodus anspricht, um das Dämpfungsglied (30) auf die kalibrierte Dämpfungsgliedeinstimmung zu programmieren, welche dem Wert des Frequenzsignals entspricht.

8. Das System nach Anspruch 7, welches des weiteren eine Speichervorrichtung (62) zum Speichern von Daten aufweist, welche repräsentativ den kalibrierten Dämpfungsgliedeinstellungen sind, und worin die Reglervorrichtung (50) angepaßt ist, um die Daten während des Kalibrierungsmodus in die Speichervorrichtung (62) einzuschreiben, und um die Daten in Abhängigkeit des gegenwärtigen Frequenzsignals während des normalen Betriebsmodus wiederzuerlangen.

9. Das System nach Anspruch 8, worin die Reglervorrichtung (50) die Kalibrierungsdämpfungsgliedeinstellung bestimmt durch einen iterativen Prozeß der Programmierung der Dämpfungsgliedvorrichtung (20) auf ausgewählte Einstellungen, um die HF-Eingangsansteuerung zu dem Verstärker (30) zu variieren, und Vergleichen des Detektorsignals von der Detektorvorrichtung (40) bei jeder programmierten Einstellung der Dämpfungsgliedeinrichtung (20) gegenüber früheren Einstellungen der Dämpfungsgliedeinrichtung (20), und Auswählen der Dämpfungsgliedeinstellung, welche den maximalen Leistungsausgang des Verstärkers (30) zur Folge hat.

10. Das System nach Anspruch 9, worin das iterative Verfahren die Schritte aufweist:

(i) Programmieren des Dämpfungsgliedes (20) auf eine Anfangseinstellung;

(ii) Empfang des Detektorsignals, welches den Ausgangsleistungspegel anzeigt;

(iii) Programmieren des Dämpfungsgliedes (20) auf eine unterschiedliche Einstellung;

(iv) Erhöhen der Dämpfungsgliedeinstellung in derselben Richtung wie die vorhergehende Dämpfungsgliedeinstellung, wo das Detektorsignal einen erhöhten Ausgangsleistungspegel bei der verschiedenen Einstellung anzeigt;

(v) Vermindern der Dämpfungsgliedeinstellung in entgegengesetzter Richtung wie die vorhergehende Dämpfungsgliedeinstellung, wo das Detektorsignal einen verminderten Ausgangsleistungspegel bei der verschiedenen Einstellung anzeigt;

(vi) Wiederholen der Schritte (iii) bis (v) bis eine ausgewählte Anzahl von Abtastungen durchgeführt wurde; und

(vii) Bestimmen der Kalibrierungsdämpfungsgliedeinstellung durch Zählen der Anzahl jeder Dämpfungsgliedeinstellung, welche verwendet wird während des iterativen Prozesses, und Auswählen der Dämpfungsgliedeinstellung, welche die höchste Verwendung erhalten hat.

**Revendications**

1. Procédé pour optimiser le niveau d'attaque d'entrée radio-fréquence appliqué à un amplificateur de micro-ondes (30) sur une largeur de bande de fréquences d'entrée, comprenant les étapes suivantes:

— fourniture de moyens commandables (20) pour faire varier le niveau d'attaque d'entrée appliqué à l'amplificateur (30) en réponse à des signaux de commande;

— fourniture d'un contrôleur central (50) pour fournir lesdits signaux de commande aux moyens commandables (20), ledit contrôleur (50) étant adapté pour fonctionner dans un mode de calibrage;

— dans ledit mode de calibrage, pour chaque fréquence considérée, détermination, par un processus itératif consistant à faire varier un paramètre d'attaque d'entrée, la valeur calibrée du paramètre d'attaque d'entrée qui entraîne la puissance de sortie maximale, caractérisé en ce que:

— ledit contrôleur (50) est adapté pour un fonctionnement dans ledit mode de calibrage et dans un mode de fonctionnement normal d'amplificateur; et

— dans ledit mode de fonctionnement normal d'amplificateur, régler ladite valeur du paramètre d'attaque d'entrée à la valeur calibrée correspondant à la fréquence présente.

2. Procédé selon la revendication 1, dans lequel ledit mode de calibrage comprend en outre une étape de stockage dans un dispositif formant mémoire (62) de données représentatives de ladite valeur calibrée pour chaque fréquence considérée.

3. Procédé selon la revendication 1, dans lequel l'étape de détermination desdites valeurs calibrées de paramètre comprend un changement itératif du niveau d'atténuation d'un atténuateur programmable (20) adapté pour atténuer sélectivement le niveau d'attaque d'entrée appliqué à l'amplificateur (30), et dans lequel ledit paramètre d'attaque d'entrée comprend le réglage de l'atténuateur programmable (20).

4. Procédé selon la revendication 3, dans lequel ledit processus itératif comprend les étapes suivantes:

(i) programmation dudit atténuateur (20) sur un réglage initial;

(ii) échantillonnage de la puissance de sortie;

(iii) détermination d'un nouveau réglage d'atténuateur et programmamion de l'atténuateur (20) sur le nouveau réglage; et

(iv) répétition des étapes (ii) et (iii) jusqu'à ce qu'un nombre prédéterminé d'échantillons ait été prélevé.

5. Procédé selon la revendication 4, dans lequel l'étape de détermination d'un nouveau réglage d'atténuateur comprend:

(i) détermination si, oui ou non, le changement précédent du réglage d'atténuateur a entraîné une puissance de sortie augmentée; et

(ii) si oui, diminution du réglage de l'atténuateur dans le même sens que le changement précédent du réglage d'atténuateur; ou

(iii) si non, augmentation du réglage d'atténuateur dans le sens opposé à celui du changement précédent.

6. Procédé selon la revendication 5, dans lequel l'étape de détermination de la valeur calibrée du réglage d'atténuateur comprend l'étape de comptage du nombre de fois que chaque réglage d'atténuateur est utilisé pendant ledit processus itératif, et de détermination de la valeur calibrée comme étant le réglage d'atténuateur qui a été le plus utilisé pendant ledit processus iteratif.

7. Système pour optimiser l'attaque d'entrée radio-fréquence appliquée à un amplificateur de microondes (30), comprenant:

— des moyens programmables (20) formant atténuateur pour atténuer sélectivement l'attaque d'entrée radiofréquence appliquée à l'amplificateur (30);

— des moyens formant détecteur (40) pour détecter la puissance de sortie radiofréquence de l'amplificateur (30) et fournir un signal de détecteur indicatif du niveau de puissance de sortie; et

— des moyens formant contrôleur (50) pouvant fonctionner en un mode de calibrage, ledit contrôleur (50) étant sensible auxdits signaux de détecteur (40), caractérisé en ce que:

— des moyens pour fournir des signaux de fréquence indicatifs de la fréquence d'attaque d'entrée radiofréquence appliquée à l'amplificateur (30) sont prévus;

— lesdits moyens formant contrôleur (50) peuvent fonctionner dans ledit mode d'étalonnage et dans un mode de fonctionnement normal;

— ledit contrôleur (50) étant sensible auxdits signaux de détecteur et auxdits signaux de fréquence pendant ledit mode de calibrage pour déterminer un réglage d'atténuateur de calibrage pour chaque fréquence considérée; et

— ledit contrôleur (50) étant sensible audit signal de fréquence dans ledit mode de fonctionnement normal pour programmer ledit atténuateur (30) sur ledit réglage d'atténuateur calibré correspondant à la valeur dudit signal de fréquence.

8. Système selon la revendication 7, comprenant en outre des moyens formant mémoire (62) pour stocker des données représentatives desdits réglages d'atténuateur calibrés, et dans lequel les moyens formant contrôleur (50) sont adaptés pour introduire lesdites données dans lesdits moyens formant mémoire (62) dans le mode de calibrage et pour récupérer des données en fonction du signal de fréquence présent, dans le mode de fonctionnement normal.

9. Système selon la revendication 8, dans lequel lesdits moyens formant contrôleur (50) déterminent le réglage d'atténuateur de calibrage par l'intermédiaire d'un processus itératif de programmation des moyens formant atténuateur (20) sur des réglages sélectionnés pour faire varier l'attaque d'entrée radiofréquence appliquée à l'amplificateur (30), de comparaison du signal de détecteur issu des moyens formant détecteur (40) pour chaque réglage programmé des moyens formant atténuateur (20) par rapport à des réglages antérieurs des moyens formant atténuateur (20), et de sélection du réglage d'atténuateur qui entraîne la puissance de sortie maximale de l'amplificateur (30).

**10.** Système selon la revendication 9, dans lequel le processus itératif comprend les étapes suivantes:

(i) programmation dudit atténuateur (20) sur un réglage initial;

(ii) réception du signal du détecteur (40) indicatif du niveau de puissance de sortie;

(iii) programmation dudit atténuateur (20) sur un réglage différent;

(iv) si le signal du détecteur (40) indique un niveau de puissance de sortie augmenté pour le réglage différent, augmentation du réglage de l'atténuateur (20) dans le même sens que le réglage d'atténuateur précédent;

(v) si le signal du détecteur (40) indique un niveau de puissance de sortie diminué pour le réglage différent, diminution du réglage de l'atténuateur (20) dans le sens opposé à celui du réglage d'atténuateur précédent;

(vi) répétition des étapes (iii) à (v) jusqu'à ce qu'un nombre sélectionné d'échantillons aient été prélevés; et

(vii) détermination du réglage d'atténuateur de calibrage en comptant le nombre de fois que chaque réglage d'atténuateur est utilisé pendant ledit processus itératif, et sélectionner le réglage d'atténuateur qui a été le plus utilisé.

FIG.1

FIG.2

FIG.3

150 ( FREQ. CAL )

155 → CLEAR HISTOGRAM

160 → READ TWT RF OUTPUT LEVEL

165 → CALCULATE NEXT ATTENUATOR SETTING

170 → # SAMPLES =N ? — NO

YES

175 → EVALUATE HISTOGRAM

180 → ATTN. FAULT ? — YES → ( FAULT )

NO

185 → FREQ. CHANGE ? — YES → ( FAULT )

NO

190 → STORE ATTN. SETTING IN BUFFER

195 → INCREMENT FREQUENCY # COUNTER

( RETURN )

FIG.4

FIG.5

FIG.6

4

FIG.7